# EUROPEAN PATENT APPLICATION

(11) **EP 3 336 069 A1**
(43) Date of publication of application: **20.06.2018**
(21) Application number: 15900992.7
(22) Date of filing: 10.08.2015
(51) Int. Cl.: C04B 41/91, B23K 26/354, C04B 41/80

(54) **METHOD FOR PROCESSING ZIRCONIA**

(71) Applicant: Hamamatsu Photonics K.K., Hamamatsu-shi, Shizuoka 435-8558 (JP)
(72) Inventor: KOMEDA, Osamu, Toyota-shi Aichi 471-8571 (JP); KONDO, Takuya, Toyota-shi Aichi 471-8571 (JP); KAWASHIMA, Toshiyuki, Hamamatsu-shi Shizuoka 435-8558 (JP); KAN, Hirofumi, Hamamatsu-shi Shizuoka 435-8558 (JP); SATOH, Nakahiro, Hamamatsu-shi Shizuoka 435-8558 (JP); SEKINE, Takashi, Hamamatsu-shi Shizuoka 435-8558 (JP); KURITA, Takashi, Hamamatsu-shi Shizuoka 435-8558 (JP); SUNAHARA, Atsushi, Osaka-shi Osaka 550-0004 (JP); MOTOHIRO, Tomoyoshi, Nagakute-shi Aichi 480-1192 (JP); HIOKI, Tatsumi, Nagakute-shi Aichi 480-1192 (JP); AZUMA, Hirozumi, Nagakute-shi Aichi 480-1192 (JP); OHSHIMA, Shigeki, Nagakute-shi Aichi 480-1192 (JP); KAJINO, Tsutomu, Nagakute-shi Aichi 480-1192 (JP); KITAGAWA, Yoneyoshi, Hamamatsu-shi Shizuoka 431-1202 (JP); MORI, Yoshitaka, Hamamatsu-shi Shizuoka 431-1202 (JP); ISHII, Katsuhiro, Hamamatsu-shi Shizuoka 431-1202 (JP); HANAYAMA, Ryohei, Hamamatsu-shi Shizuoka 431-1202 (JP); NISHIMURA, Yasuhiko, Toyota-shi Aichi 470-0334 (JP); MIURA, Eisuke, Tsukuba-shi Ibaraki 305-8568 (JP)
(74) Representative: Boult Wade Tennant
(86) International application number: PCT/JP2015/072670
(87) International publication number: WO 2017/026038

(57) **Abstract**

A problem to be solved is to provide a method for processing zirconia without producing a monoclinic crystal. The solution is a method for processing zirconia, including the step of irradiating the zirconia with a laser with a pulse duration of 10⁻¹² seconds to 10⁻¹⁵ seconds at an intensity of 10¹³ to 10¹⁵ W/cm².

## Description

### Field of the Invention

The present invention relates to a method for processing zirconia, particularly a method for processing zirconia in which zirconia is irradiated with a laser with a pulse duration of 10⁻¹² to 10⁻¹⁵ seconds at an intensity of 10¹³ to 10¹⁵ W/cm².

### Description of the Related Art

Zirconia (ZrO₂) has a high melting point of 2715°C, scarcely evaporating below 2200°C, and has excellent heat-resistance, durability, hardness, and chemical stability. Zirconia has been used not only as a refractory material but also as a solid electrolyte utilizing its oxygen ion conductivity. Now, with the mechanical and thermal properties of zirconia attracting attention, it has come to be applied as high mechanical strength and high toughness ceramics.

Non-Patent Literature 1 considers dental applications since zirconia has a remarkably excellent bending strength and fracture toughness compared with many other ceramics.

In cutting processing or perforation processing of zirconia, machining with a cutter, a drill, or the like and thermal energy processing with a YAG or CO₂ laser have been carried out conventionally.

Patent Literature 1 discloses that, relative to a problem in that a layered product composed of a metal material and a ceramic material and processed by a conventional processing method has some metal material stuck to the processed surface of the ceramics and then fails to obtain desired characteristics, irradiating the ceramic material side of a layered member composed of a metal material and a ceramic material with a laser beam having a pulse duration of 40 to 80 nsec, a peak output of 0.1 to 10 GW/cm² per pulse, and a wavelength of 170 to 700 nm will allow the laminated member to be processed without metal material being stuck to the processed surface of the ceramics.

Patent Literature 2 proposes that, in order to manufacture coping caps (metal frames for crown restorations) of zirconia-based ceramic with better shape accuracy, coping caps of zirconia-based ceramic in a semi-sintered state or a sintered state are irradiated with a laser having a wavelength in a visible region or a near-infrared region, a peak output of 16 kW or more, and a pulse duration of 16 to 30 nsec.

### Citations List

### Patent Literature

Patent Literature 1 Japanese Laid-open Patent Publication No. H10-099980
Patent Literature 2 Japanese Laid-open Patent Publication No. 2011-083448

### Non-Patent Literature

Non-Patent Literature 1 Ban, S. (2007) "Properties of zirconia for realization of all-ceramic restoration" The Shika Gakuho, Vol. 107, No. 6, pp. 670-684

### Summary of Invention

### Problem to be Solved by the Invention

There are three crystal systems of zirconia: monoclinic crystal, tetragonal crystal, and cubical crystal, and it transits in accordance with temperature. At an elevated temperature of 1170°C, a transition from the monoclinic crystal to the tetragonal crystal occurs, and, at a lowered temperature of 950°C, a transition from the tetragonal crystal to the monoclinic crystal occurs. It is also reported that a large mechanical energy loaded by mechanical processing such as grinding, sand blast, or the like facilitates a phase transition (martensite transition) from the tetragonal crystal to the monoclinic crystal (Non-Patent Literature 1).

The monoclinic crystal is such a structure as is a deformed tetragonal crystal, having a larger volume than the tetragonal crystal, and a transition between the monoclinic crystal and the tetragonal crystal is accompanied by a volume change of about 4%. In a phase transition from the tetragonal crystal to the monoclinic crystal, the transition in an amount of up to a certain level causes surface compressive stress through volume expansion, resulting in enhanced strength (biaxial bending strength). However, too much transition amount causes cracks and decreased strength.

Based on this, Non-Patent Literature 1 discloses the recovery of the monoclinic crystal to the tetragonal crystal by heat treatment at about 1000°C. This process reduces an amount of the monoclinic crystal, but there remains room for further improvement (further reducing it close to zero).

Patent Literature 1 and Patent Literature 2 disclose that when a laser with a pulse duration at a level of nanometers is used in processing ceramics including zirconia, changes in the surface condition and dimensions of the ceramics are small. But they don't consider the types of crystal systems. The present inventors irradiated zirconia with a laser with a pulse duration of 300 picometers, which is shorter than nanometers, and confirmed the existence of monoclinic crystals on the surface of the zirconia.

An object of the present invention is to provide a method for processing zirconia without producing monoclinic crystals.

### Solution to Problem

The present invention provides the following aspects:
(1) a method for processing zirconia, including the step of irradiating the zirconia with a laser with a pulse duration of 10⁻¹² seconds to 10⁻¹⁵ seconds at an intensity of 10¹³ to 10¹⁵ W/cm²,
(2) the method according to (1), wherein the irradiating is conducted to a monoclinic crystal produced on a surface of the zirconia,
(3) the method according to (1), further including the step of joining the irradiated zirconia and another material,
(4) the method according to (3), wherein the zirconia and the material to be joined are different in thermal expansion coefficient,
(5) the method according to (1), wherein the laser has a wavelength of about 810 nm, and
(6) the method according to (1), wherein the zirconia contains a solid solution with any of Y, Ca, Mg, and Ce ions or a combination thereof.

### Advantageous Effects

According to the present invention, materials (zirconia) that are processed by laser irradiation have little dimensional change. This is considered to be because the pulse duration at a level of femtoseconds restricts the laser absorption depth to the outermost surface portion of the zirconia. This allows monoclinic crystals on the zirconia surface to be removed or modified into the tetragonal crystals without affecting the zirconia below the outermost surface. Then, the absence of monoclinic crystals can achieve high strength. In addition, owing to the absence of monoclinic crystals, the tetragonal crystal is transformed to the monoclinic crystal when loaded with a stress (stress-induced transformation strengthening mechanism), by which the expansion of cracks expectedly inhibited.

The laser irradiation according to the present invention also allows the zirconia to be processed to form roughness on its surface. This roughness helps increase the joining area between the zirconia and another material and enhance the joining ability. In joining materials having different thermal expansion coefficients, the roughness also helps buffer the thermal expansion difference and enhance the joining ability between the zirconia and another material.

Further, when the laser irradiation according to the present invention causes cracks or unstuck shear faces to be formed on the outermost surface of the zirconia and the joined materials are loaded with stress, only the stress-loaded cracks and shear faces are destroyed, and the joined portions can be inhibited from exfoliating all over. Similarly, when a stress is loaded by a thermal expansion difference between the joined material and the zirconia, the allover exfoliation of the joined portion can be inhibited.

### Brief Description of the Drawings

Fig. 1 is a schematic diagram of stress-induced transformation strengthening mechanism by which crystal phase transition inhibits the expansion of cracks.
Fig. 2 illustrates photomicrographs of the zirconia which was irradiated with a laser under various conditions.
Fig. 3 illustrates diagrams indicating the measurement results of the surfaces of the zirconia which was irradiated with a laser under various conditions.
Fig. 4 illustrates diagrams indicating the XRD measurement results of the surfaces of the zirconia which was irradiated with a laser under various conditions.
Fig. 5 illustrates schematic diagrams of the method for processing zirconia using a laser according to the present invention.

### Description of Embodiments

In the method for processing zirconia according to the present invention, zirconia is irradiated with a laser with a pulse duration of 10⁻¹² seconds to 10⁻¹⁵ seconds at an intensity of 10¹³ to 10¹⁵ W/cm².

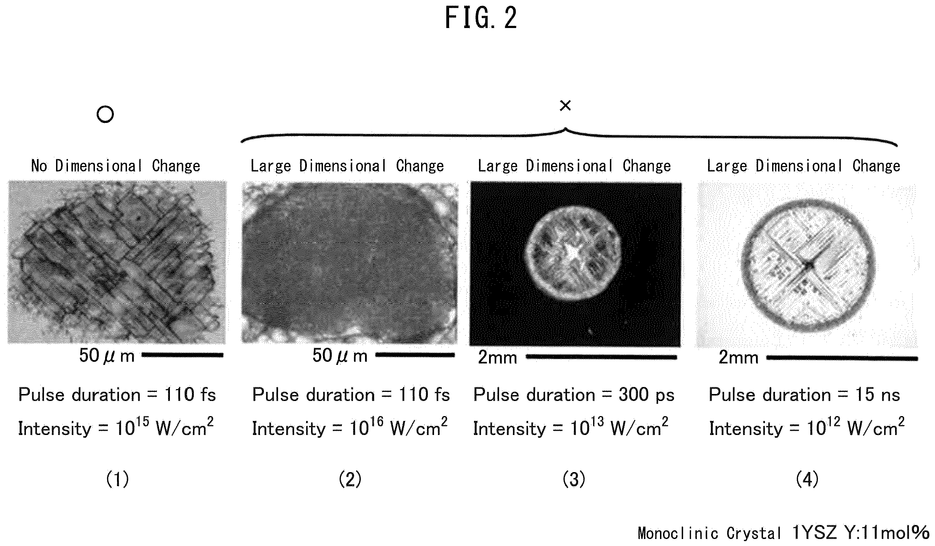

Such laser irradiation under particular conditions achieves remelting and removal on only the surface of the processed material (zirconia), as illustrated in Fig. 2 (1). Thus, the processed material (zirconia) has little dimensional change.

Without wishing to be bound by any particular theory, the mechanism of the present invention may be considered as follows. Processing only the surface of a material to be processed is considered to increase the surface temperature, causing melt recrystallization or evaporation. Still, the temperature increase is not limited to the outermost surface only, but the vicinity of the surface is overheated, whereby melting and internal boiling may cause a large shape change. Now, the intensity of a laser is increased, and the laser having a raised electric field strength is irradiated. Assuming that from the laser-irradiated atom, nuclear electrons are removed through relativistic effect and that the coulomb repulsion of the ionized atom causes the surface of the processed material to be exfoliated and removed, thermal energy does not reach the inside of the processed material nor cause a dimensional change due to heat. In the case of mechanical processing such as grinding, sand blast, or the like, a large mechanical energy is loaded, and the inside of the processed material may transform from the tetragonal crystal to the monoclinic crystal, decreasing the strength, but according to the present invention, thermal energy does not reach the inside of the processed material, and accordingly there is no such case where the internal crystal structure is changed with the strength decreased. However, when the intensity is raised with the pulse duration still at a conventional level, for example, a level of nanometers, up to the electric field strength at which coulomb repulsion occurs, the incident energy becomes very large, and the excessive heat melts or evaporates the inside of the processed material, thereby causing a dimensional change.

The laser pulse duration is 10⁻¹² seconds to 10⁻¹⁵ seconds. A laser pulse duration longer than this range will cause the surface of the zirconia to be melted and evaporated (ablation), so that the laser-irradiated portion results in having a hole, and the shape of the zirconia changes significantly.

The laser intensity is 10¹³ to 10¹⁵ W/cm². A laser intensity larger than this range will cause the surface of the zirconia to be melted and evaporated (ablation), so that the laser-irradiated portion results in having a hole, and the shape of the zirconia changes significantly, as is the case with a longer pulse duration. At an intensity lower than 10¹³, the surface of the processed material (zirconia) fails to be exfoliated by coulomb explosion nor heated in an instant (at a pulse duration at a level of femtoseconds).

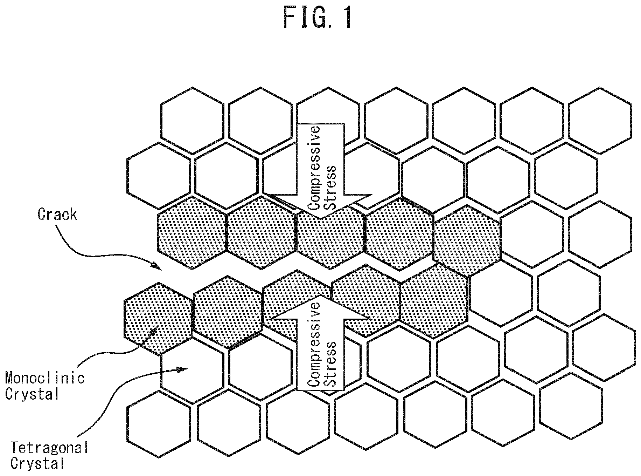

According to the present invention, the laser irradiation may be conducted to monoclinic crystals produced on the zirconia surface. This allows the monoclinic crystals on the zirconia surface to be removed or modified into the tetragonal crystals. The absence of monoclinic crystals can provide high strength. In addition, owing to the absence of monoclinic crystals, the tetragonal crystal is transformed to the monoclinic crystal when loaded with a stress (stress-induced transformation strengthening mechanism), through which cracks are expectedly inhibited. Stress-induced transformation strengthening mechanism will be described with reference to Fig. 1. When a large pressure is applied to zirconia, its crystal structure is instantly transformed from the tetragonal crystal to the monoclinic crystal (phase transition) without being heat-treated. This is called martensitic transformation. When a microcrack is created by coincidence on a zirconia material loaded with a bending stress, compressive stress is concentrated at the end of the crack, and the crack, if in a material to which no phase transition occurs, will expand because of the concentrated stress. A martensite transformation caused by a stress from the tetragonal crystal to the monoclinic crystal expands the crystal, causes a compressive stress on the cracked portions, and inhibits the expansion of the cracks, because the monoclinic crystal has a larger volume than the tetragonal crystal. Fig. 1 illustrates a schematic diagram of stress-induced transformation strengthening mechanism by which crystal phase transition inhibits the expansion of cracks.

According to the present invention, the laser-irradiated zirconia may further have another material joined.

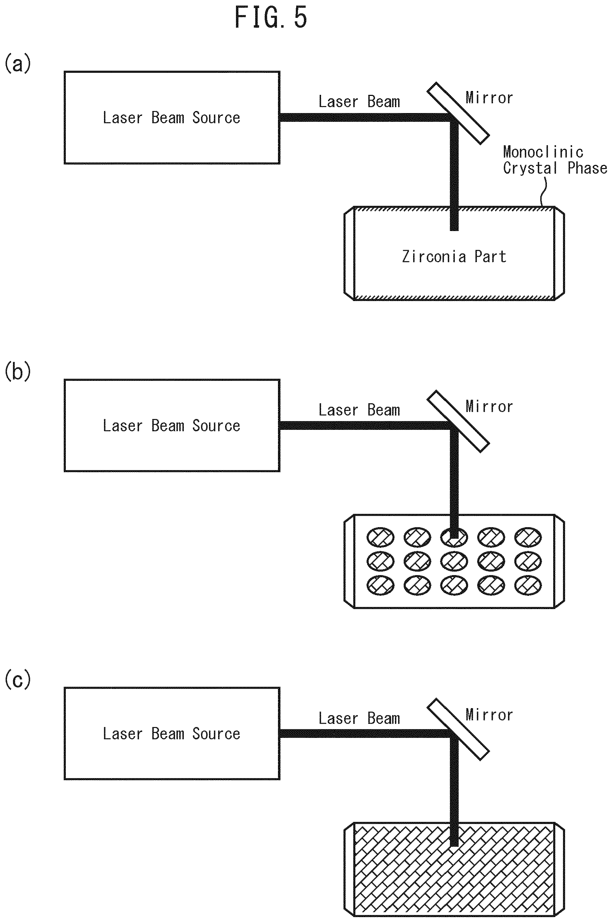

The laser irradiation can form roughness on the surface of the zirconia. Because the zirconia has a rough surface, joining it and another material gives an increased joining area and then an enhanced joining ability. The laser irradiation may be conducted all over the joined face or, as in Fig. 5 (b), dispersed in spots over the joined face. This allows the surface roughness, or surface ruggedness, to be controlled and can achieve a desired joining ability.

The laser irradiation also causes the outermost surface of the zirconia to have cracks or unstuck shear faces (shear planes) formed thereon (see Fig. 2 (1)). When the joined materials are loaded with stress, only the stress-loaded cracks and shear faces are destroyed (exfoliated), and the exfoliation of the joined portions can be inhibited from expanding all over.

A material to be joined may have a different thermal expansion coefficient than zirconia.

In joining materials having different thermal expansion coefficients, the rough surface buffers the thermal expansion difference and enhances the joining ability between the zirconia and the other material.

In addition, even when the cracks and unstuck shear faces (shear planes) formed by the laser irradiation on the outermost surface of the zirconia are loaded with a stress due to a thermal expansion difference between the joined materials and the zirconia, only the stress-loaded cracks and shear faces are destroyed, and the exfoliation of the joined portions can be inhibited from expanding all over.

According to the present invention, the laser wavelength may be 810 nm.

The laser wavelength is not particularly limited but a wavelength in a visible region or near-infrared region may be used. Currently, however, a wavelength of about 810 nm is used in order to achieve a pulse duration at a femtosecond level. It is about 810 nm because of variations of several % (±10%).

The zirconia may contain a solid solution with any of Y, Ca, Mg, and Ce ions or a combination thereof. Among the crystal phases of pure zirconia at room temperature, the monoclinic crystal is the most stable. However, when zirconia contains a solid solution with ions such as Y, Ca, Mg, and Ce, which have a larger ion radius than Zr, oxygen vacancies are formed in the structure, and, at room temperature, the cubical crystal or the tetragonal crystal is stable or metastable. This inhibits a structural destruction which accompanies a phase transition due to heating and cooling. A sintered material composed of an approximately 100% tetragonal crystal zirconia is referred to as a tetragonal zirconia polycrystal, and Y₂O₃-ZrO₂ (Y-TZP), Ce₂O₃-ZrO₂ (Ce-TZP), or the like may be used.

### Examples

The present invention will be described with reference to the following examples. The scope of the present invention is not limited to these examples.

The surface of the zirconia which was irradiated with a laser at different pulse durations and intensities was observed. As a reference for the present invention, a laser irradiation was conducted under the conditions out of the range of the present invention.

As zirconia for laser irradiation, a single crystal Y-stabilized zirconia (containing 11% Y) was prepared and irradiated with a laser under the conditions (pulse duration and intensity) indicated in Fig. 2. The laser wavelength was set to 810 nm. Fig. 2 indicates the photomicrographs of the surface of the laser-irradiated zirconia.
As indicated in Fig. 2 (1), only the surface of the zirconia irradiated with a laser with a pulse duration of 110 fsec at an intensity of 10¹⁵ W/cm², which is within the range of the present invention, achieved remelting and removal. As the result, the zirconia had little dimensional change. In Fig. 2 (1), it was also observed that cracks and unstuck shear faces (shear planes) were formed on the laser-irradiated portion.
Fig. 2 (2) is a case where a laser with a pulse duration of 110 fsec was irradiated at an intensity of 10¹⁶ W/cm², in which the intensity was larger than the range of the present invention, so that the surface melted and evaporated (ablation), resulting in having a hole at the laser-irradiated portion and in changing the size and shape of the zirconia significantly.
Fig. 2 (3) is a case where a laser with a pulse duration of 300 fsec was irradiated at an intensity of 10¹³ W/cm², in which the pulse duration was larger than the range (femtosecond levels) of the present invention, so that the dimensional change of the zirconia was significant.
Fig. 2 (4) is a case where a laser with a pulse duration of 15 nsec was irradiated at an intensity of 10¹² W/cm², in which the intensity was made lower than the range of the present invention but the pulse duration was larger than the range (femtosecond levels) of the present invention, so that the dimensional change of the zirconia was significant.

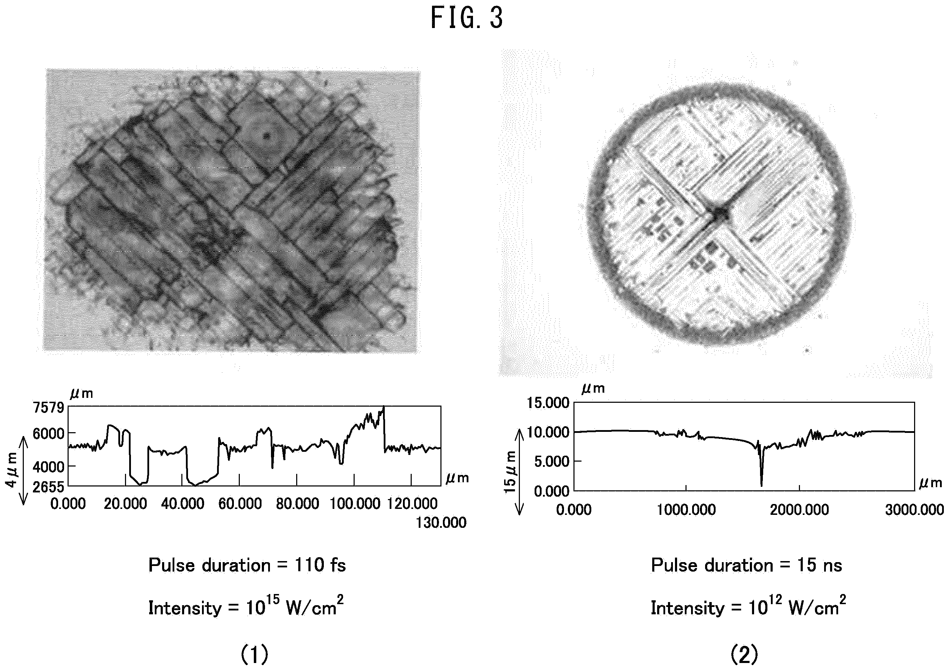

The surface of laser-irradiated zirconia was measured for shape. The results are indicated in Table 3.
As seen in Fig. 3 (1), the surface of the zirconia irradiated with a laser with a pulse duration of 110 fsec at an intensity of 10¹⁵ W/cm², which are within the range of the present invention, exhibited roughnesses about 4 µm high.
Fig. 3 (2) is a case where a laser with a pulse duration of 15 nsec was irradiated at an intensity of 10¹² W/cm², in which the intensity was made lower than the range of the present invention but the pulse duration was larger than the range (femtosecond levels) of the present invention, so that the laser-irradiated portion resulted in having a hole about 15 µm deep and the shape change of the zirconia was significant.

The surface of the laser-irradiated zirconia was measured by XRD, and the crystal structure of the surface was examined. The results are indicated in Table 4. The measurement conditions of XRD were an angle of incidence of 10° and a wavelength λ = 1 Å (1 × 10⁻¹⁰ m).

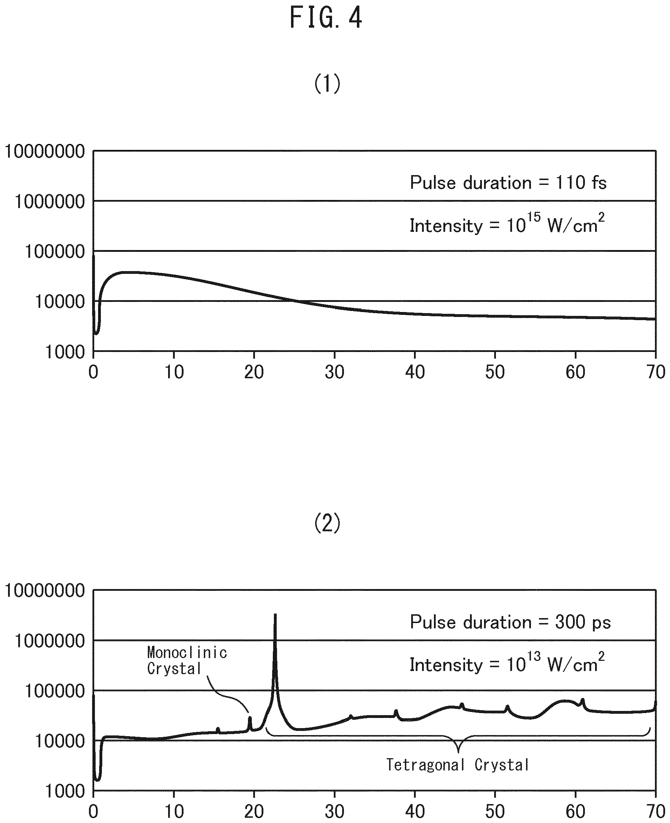

Fig. 4 (1) is the result of XRD of the laser with a pulse duration of 110 fsec irradiated at an intensity of 10¹⁵ W/cm² within the range of the present invention, and it indicated no peak of a monoclinic crystal.
Fig. 4 (2) is a case where a laser with a pulse duration of 300 psec was irradiated at an intensity of 10¹³ W/cm², in which the intensity was made to fall within the range (the lower limit) of the present invention but the pulse duration was larger than the range (femtosecond levels) of the present invention, and a peak of a monoclinic crystal was confirmed, though minute.

## Claims

1. A method for processing zirconia, comprising the step of irradiating the zirconia with a laser with a pulse duration of 10⁻¹² seconds to 10⁻¹⁵ seconds at an intensity of 10¹³ to 10¹⁵ W/cm².

2. The method according to claim 1, wherein the irradiating is conducted to a monoclinic crystal produced on a surface of the zirconia.

3. The method according to claim 1, further comprising the step of joining the irradiated zirconia and another material.

4. The method according to claim 3, wherein the zirconia and the material to be joined are different in thermal expansion coefficient.

5. The method according to claim 1, wherein a wavelength of the laser is 810 nm.

6. The method according to claim 1, wherein the zirconia contains a solid solution with any of Y, Ca, Mg, and Ce ions or a combination thereof.
